# EUROPEAN PATENT SPECIFICATION

(11) **EP 3 636 799 B1**
(45) Date of publication and mention of the grant of the patent: **02.08.2023**
(21) Application number: 17912428.4
(22) Date of filing: 07.06.2017
(51) Int. Cl.: C23C 16/455, C23C 16/458, H01L 31/18, C23C 16/30, C23C 16/32, C23C 16/34, C23C 16/40, C23C 16/44, C23C 16/50

(54) **COATING METHOD FOR TUBE-TYPE PERC SOLAR CELLS**
BESCHICHTUNGSVERFAHREN FÜR ROHRARTIGE PERC-SOLARZELLEN
PROCÉDÉ DE REVÊTEMENT POUR CELLULES SOLAIRES PERC DE TYPE À TUBE

(43) Date of publication of application: 15.04.2020
(73) Proprietor: Zhejiang Aiko Solar Energy Technology Co., Ltd., Yiwu, Zhejiang 322009 (CN); Guangdong Aiko Solar Energy Technology Co., Ltd., Foshan, Guangdong 528000 (CN)
(72) Inventor: LIN, Kang-Cheng, Suxi Town Yiwu Zhejiang 322009 (CN); FANG, Jiebin, Suxi Town Yiwu Zhejiang 322009 (CN); LAI, Chun-Wen, Suxi Town Yiwu Zhejiang 322009 (CN); HO, Ta-neng, Suxi Town Yiwu Zhejiang 322009 (CN); CHEN, Gang, Suxi Town Yiwu Zhejiang 322009 (CN)
(74) Representative: Steinbauer, Florian
(86) International application number: PCT/CN2017/087443
(87) International publication number: WO 2018/223314

(56) References cited:
- CN-A- 101 024 213
- CN-A- 103 996 741
- CN-A- 104 025 304
- CN-A- 104 419 909
- CN-A- 106 463 395
- CN-A- 106 531 839
- US-A1- 2013 186 464
- US-A1- 2016 379 859
- US-B2- 9 040 170
- 32TH EUROPEAN PHOTOVOLTAIC SOLAR ENERGY CONFERENCE, PROCEEDINGS OF THE 32TH INTERNATIONAL CONFERENCE, WIP-RENEWABLE ENERGIES, SYLVENSTEINSTR. 2 81369 MUNICH, GERMANY, 22 July 2016 (2016-07-22), XP040679714, ISBN: 978-3-936338-41-6

## Description

### FIELD

The present invention relates to the field of PERC solar cells, and more specifically, to a coating device and a coating method for a tube-type PERC solar cell.

### BACKGROUND

In order to meet the ever-rising requirements for the photoelectric conversion efficiency of crystalline silicon cells, people began to study the rear surface passivation technologies of solar cells. At present, the mainstream method is to use a plate PECVD system to coat the rear side. The plate PECVD system consists of different chambers; each chamber is used for coating one layer of film. Once the device is fixed, the number of layers of a composite film is fixed. Therefore, a disadvantage of the plate PECVD system is that the combination of layers in the composite film cannot be flexibly adjusted; thus, it is impossible to optimize the passivation effect of the rear surface film, which limits the photoelectric conversion efficiency of the cell. Meanwhile, the plate PECVD system employs an indirect plasma method, which gives a less than ideal passivation effect of the film. The plate PECVD system also has other disadvantages including low uptime and long maintenance time, which affects its capacity and yield.

The present invention employs tubular PECVD technology to deposit a composite film on the rear surface of a silicon wafer in order to produce a high-efficiency PERC solar cell. Due to the fact that tubular PECVD technology employs a direct plasma method and could flexibly adjust the composition and combination of layers in a composite film, the passivation effect of the film is good, and the photoelectric conversion efficiency of the PERC solar cell can be significantly improved. The excellent passivation ability and process flexibility of tubular PECVD technology also allow the thickness of an aluminum oxide film to be reduced, thus reducing the consumption of TMA. Meanwhile, tubular PERC technology can be easily maintained and has a high uptime. In view of the above, employing tubular PECVD technology to produce high-efficiency PERC cells has a significant overall cost advantage over employing plate PECVD technology.

Despite the above, the cells produced by tubular PECVD technology have poor appearance quality and low electroluminescence (EL) yield, especially a high proportion of EL scratches, due to scratching issue of the silicon wafer; these drawbacks prevent the application of this technology in mass production.

In a tubular PECVD coating device, a silicon wafer is first inserted into a graphite boat, and then the graphite boat is fed into a quartz tube for coating deposition. In the graphite boat, the silicon wafer is fixed to the graphite boat wall via three pins; one surface of the silicon wafer is in contact with the graphite boat wall, and a film is deposited on the other surface of the silicon wafer. To guarantee the formation of a uniform coating, the silicon wafer should be in tight contact with the graphite boat wall. Therefore, the width of the pin slot is set to be small; about 0.25 mm. During the insertion process, the silicon wafer rubs against the graphite boat wall, which causes that the surface of the silicon wafer adjacent to the graphite boat wall is scratched.

When using tubular PECVD to coat the front surface of a conventional solar cell, scratching does not affect the quality of the cell product. The reason is in that there are no p-n junctions and coating at the rear surface of the silicon wafer, and hence, scratches would not affect the electrical performance and the EL yield of the cell.

However, when using tubular PECVD to form the rear film of a PERC cell, scratching would seriously affect the pass rate of the cell product. The problem is: when being inserted into the graphite boat, the front surface of the silicon wafer would be in contact with the graphite boat wall, scratching the p-n junctions at the front surface; as a result, scratches would be present in the EL test, and the electrical performance of the cell would be affected.

For the same graphite boat, it is required to wash and pre-process the graphite boat before use and after a certain number of coating, so as to ensure satisfactory coating effects. A common pre-processing method is to coat the surface of the graphite boat with a thin layer of silicon nitride with the purpose of reducing absorption of the coating by the graphite boat during subsequent coating process of the silicon wafer, thereby guaranteeing thickness and quality of the coating on the silicon wafer.

Regarding the rear coating of the tube-type PERC solar cell, the conventional pre-processing of the graphite boat generally includes three steps of baking, coating the boat with a wafer inserted with silicon nitride and coating an empty boat with silicon nitride. The time for coating the boat with a wafer inserted with silicon nitride is long. The inserted wafer is to prevent a thick coating at a position where the silicon wafer is in contact with the graphite boat from affecting the deposition of aluminum oxide (Al₂O₃) on the rear surface and further influencing EL yield and photoelectric conversion efficiency of the cell. It takes a short time to coat the empty boat with silicon nitride and the purpose of this action is to coat a thin layer of silicon nitride on the pin of the graphite boat, which reduces the damage to the pin by the silicon wafer and plays a role of protecting the pin. Accordingly, broken edges of the silicon wafer are reduced, and breakage rate and poor appearance rate of the silicon wafer are reduced.

However, silicon nitride has a high resistivity, which affects uniformity of the aluminum oxide coating on the rear surface. As a result, the EL test would encounter cornered black zone, black zone of the pin and the like, which affects the EL yield of the cell. It is also discovered in the product that the cell with EL black zone tends to have low conversion efficiency. Coating the boat with a wafer inserted with silicon nitride puts a huge demand on silicon wafers. As the process for coating the boat with a wafer inserted is time-consuming, the silicon wafer would bend a lot due to a thick coating on its surface, which suspends the coating process, requires re-coating and occupies the production time. If some unqualified wafers are in use, it will cause more bending. Therefore, the quality of the silicon wafer for pre-coating the boat with a wafer inserted cannot be too poor, which results in high consumption of silicon wafers and further increases the costs.

US2016/379859 discloses a graphite boat for processing wafers . The article " Surface passivation by ALOx deposited in an industrial low frequency PECVD equipment " by R. Monna et al. , 32nd European Photovoltaic Solar Energy Conference and Exhibition , proceedings of the 32nd international conference , wip-renewable energies , Munich , published on 22-07-2016 discloses a method of coating a wafer with AlOx.

### SUMMARY

A coating method according to the invention is defined in the appended claims.

An objective of the present invention is to provide a coating device for a tube-type PERC solar cell. With a simple structure, the coating device simplifies the pre-processing steps of the graphite boat, reduces consumption of silicon wafers, avoids scratches on the silicon wafer and boosts the EL yield of the cell.

Another objective of the present invention is to provide a coating method for a tube-type PERC solar cell. The coating method simplifies the pre-processing steps of the graphite boat, reduces consumption of silicon wafers, avoids scratches on the silicon wafer and boosts the EL yield of the cell.

To achieve the objectives above, the present invention provides a coating device for a tube-type PERC solar cell. The coating device comprises a wafer loading area, a furnace body, a gas cabinet, a vacuum system, a heating system, a control system and a graphite boat, wherein the gas cabinet is provided with a first gas line for feeding silane, a second gas line for feeding ammonia, a third gas line for feeding trimethylaluminum, a fourth gas line for feeding nitrous oxide and a fifth gas line for feeding methane;
the graphite boat is used for loading and unloading a silicon wafer, and pre-processing is performed to the graphite boat before use or after several coating, wherein the pre-processing includes:
baking the graphite boat; and
coating at least one layer of silicon carbide film on a surface of the baked graphite boat.

As an improvement to the above technical solutions, the pre-processing includes:
placing the graphite boat in a tubular PECVD coating device for baking the graphite boat at a temperature of 300-480°C for 10-60min; and
placing the graphite boat, which has been baked and taken out, in the tubular PECVD coating device again to coat the at least one layer of silicon carbide film on the surface of the graphite boat.

As an improvement to the above technical solutions, a step of coating the silicon carbide film includes:
raising temperature to 380-480°C and feeding ammonia at a flow rate of 1-8slm for 2-10min with plasma power of 2000-5000w;
feeding methane at a flow rate of 2-8slm and silane at a flow rate of 200-800sccm for 5-30s;
feeding methane at a flow rate of 2-8slm and silane at a flow rate of 200-800sccm for 1-4 hours with plasma power of 3000-10000w; and
lowering the temperature to 350-400°C and taking out the graphite boat.

As an improvement to the above technical solutions, the step of coating the silicon carbide film includes:
raising the temperature to 400-460°C and feeding ammonia at a flow rate of 2-6slm for 3-8min with plasma power of 3000-4000w;
feeding methane at a flow rate of 3-6slm and silane at a flow rate of 300-600sccm for 10-20s;
feeding methane at a flow rate of 3-6slm and silane at a flow rate of 300-600sccm for 2-3 hours with plasma power of 5000-8000w; and
lowering the temperature to 370-390°C and taking out the graphite boat.

As an improvement to the above technical solutions, the graphite boat includes a pin which includes a pin shaft, a pin cap, and a pin base; the pin shaft is mounted on the pin base; the pin cap is connected to the pin shaft; a pin slot is formed among the pin shaft, the pin cap, and the pin base; and a depth of the pin slot is 0.5-1mm.

As an improvement to the above technical solutions, the pin slot of the graphite boat has the depth of 0.6-0.8 mm, a diameter of the pin base is 6-15 mm, an angle of inclination of an inclined surface of the pin cap is 35-45 degrees, and a thickness of the pin cap is 1-1.3 mm.

As an improvement to the above technical solutions, the pin slot of the graphite boat has the depth of 0.7-0.8mm, the diameter of the pin base is 8-12mm, the angle of inclination of the inclined surface of the pin cap is 37-42 degrees, and the thickness of the pin cap is 1.1-1.2mm.

Correspondingly, the present invention also discloses a coating method for a tube-type PERC solar cell. The coating method comprises:
(1) baking a graphite boat;
(2) coating at least one layer of silicon carbide film on a surface of the baked graphite boat; and
(3) placing a processed silicon wafer on the graphite boat and sending the processed silicon wafer via the graphite boat into a tubular PECVD coating device, so as to form a rear composite film on a surface of the silicon wafer, wherein the rear composite film includes an aluminum oxide film, a silicon dioxide film, a silicon oxynitride film and a silicon nitride film.

As an improvement to the above technical solutions, the coating method comprises:
(1) placing the graphite boat in the tubular PECVD coating device for baking the graphite boat at a temperature of 300-480°C for 10-60min;
(2) placing the graphite boat, which has been baked and taken out, in the tubular PECVD coating device again to coat the surface of the graphite boat with the at least one layer of silicon carbide film, wherein a method of coating the silicon carbide film includes:
   raising temperature to 380-480°C and feeding ammonia at a flow rate of 1-8slm for 2-10min with plasma power of 2000-5000w;
   feeding methane at a flow rate of 2-8slm and silane at a flow rate of 200-800sccm for 5-30s;
   feeding methane at a flow rate of 2-8slm and silane at a flow rate of 200-800sccm for 1-4 hours with plasma power of 3000-10000w; and
   lowering the temperature to 350-400°C and taking out the graphite boat; and
(3) placing a processed silicon wafer on the graphite boat and sending the processed silicon wafer via the graphite boat into the tubular PECVD coating device to form the rear composite film, wherein a method of coating the rear composite film includes:
   depositing the aluminum oxide film using TMA and N₂O, wherein a gas flow rate of TMA is 250-500 sccm, a ratio of TMA to N₂O is 1 to 15-25, and plasma power is 2000-5000w;
   depositing the silicon oxynitride film using silane, ammonia, and nitrous oxide, wherein a gas flow rate of silane is 50-200 sccm, a ratio of silane to nitrous oxide is 1 to 10-80, a flow rate of ammonia is 0.1-5 slm, and plasma power is 4000-6000w;
   depositing the silicon nitride film using silane and ammonia, wherein the gas flow rate of silane is 500-1000 sccm, a ratio of silane to ammonia is 1 to 6-15, a deposition temperature of silicon nitride is 390-410 °C, a deposition time is 100-400s, and plasma power is 10000-13000w; and
   depositing the silicon dioxide film using nitrous oxide, wherein a flow rate of nitrous oxide is 0.1-5 slm, and plasma power is 2000-5000w.

As an improvement to the above technical solutions, the coating method comprises:
(1) placing the graphite boat in the tubular PECVD coating device for baking the graphite boat at a temperature of 320-420°C for 20-40min;
(2) placing the graphite boat, which has been baked and taken out, in the tubular PECVD coating device again to coat the surface of the graphite boat with the at least one layer of silicon carbide film, wherein a method of coating the silicon carbide film includes:
   raising temperature to 400-460°C and feeding ammonia at a flow rate of 2-6slm for 3-8min with plasma power of 3000-4000w;
   feeding methane at a flow rate of 3-6slm and silane at a flow rate of 300-600sccm for 10-20s;
   feeding methane at a flow rate of 3-6slm and silane at a flow rate of 300-600sccm for 2-3 hours with plasma power of 5000-8000w; and
   lowering the temperature to 370-390°C and taking out the graphite boat; and
(3) placing a processed silicon wafer on the graphite boat and sending the processed silicon wafer via the graphite boat into the tubular PECVD coating device to form the rear composite film, wherein a method of coating the rear composite film includes:
   depositing the aluminum oxide film using TMA and N₂O, wherein a gas flow rate of TMA is 250-500 sccm, a ratio of TMA to N₂O is 1 to 15-25, a deposition temperature of the aluminum oxide film is 250-300 °C, a deposition time is 50-300s, and plasma power is 2000-5000w;
   depositing the silicon oxynitride film using silane, ammonia, and nitrous oxide, wherein a gas flow rate of silane is 50-200 sccm, a ratio of silane to nitrous oxide is 1 to 10-80, a flow rate of ammonia is 0.1-5 slm, a deposition temperature of the silicon oxynitride film is 350-410 °C, a deposition time is 50-200s, and plasma power is 4000-6000w;
   depositing the silicon nitride film using silane and ammonia, wherein a gas flow rate of silane is 500-1000 sccm, a ratio of silane to ammonia is 1 to 6-15, a deposition temperature of the silicon nitride film is 390-410 °C, a deposition time is 100-400s, and plasma power is 10000-13000w; and
   depositing the silicon dioxide film using nitrous oxide, wherein a flow rate of nitrous oxide is 0.1-5 slm, and plasma power is 2000-5000w.

Implementation of the present invention achieves following advantageous effects:
I. The present invention provides a coating device for a tube-type PERC solar cell comprising a heating system and a gas cabinet, wherein the gas cabinet is provided with a first gas line for feeding silane, a second gas line for feeding ammonia, a third gas line for feeding trimethylaluminum, a fourth gas line for feeding nitrous oxide and a fifth gas line for feeding methane. Before use or after several coating, the graphite boat should be pre-processed. Specifically, the graphite boat is baked by a heating system and the surface of the graphite boat is coated with at least one layer of silicon carbide film by the gas cabinet. When the graphite boat is coated with the silicon carbide film, it is unnecessary to insert the silicon wafer into the boat. Because the silicon carbide is a semiconductor, the rear aluminum oxide coating has satisfactory uniformity, which reduces EL defects such as EL black zone and the like. The steps of pre-processing the graphite boat are decreased to two steps, i.e., baking and coating of silicon carbide, which saves time and enhances production efficiency. In addition, because there are a great many of fine graphite particles dispersed in the silicon carbide matrix, the silicon carbide matrix has an extreme small friction coefficient and exhibits a good self-lubricating property. On this account, when the silicon wafer is inserted into the graphite boat, there are fewer scratches on the silicon wafer, which greatly reduces the proportion of the EL scratches and increases the EL yield of the cell.

Furthermore, the present invention adjusts the diameters of the pin shaft and the pin base to reduce the depth of the inside of the pin slot. As a result, the gap between the silicon wafer and the pin base at the position of the pin is reduced. Further, the amount of gas reaching and coating the rear surface of the silicon wafer is reduced, and boat teeth marks at the front surface edges of the cell thus are much less likely to occur. In addition, the present invention adequately increases the angle of inclination of the inclined surface of the pin cap and the thickness of the pin cap, and adjusts the automatic wafer inserter, thereby slightly increasing the distance between the silicon wafer and the graphite boat wall on inserting the wafer, and reducing scratching. Meanwhile, it is possible to reduce the impact force on the silicon wafer from the graphite boat wall when the silicon wafer is sliding down, reducing breakage rate.

II. The present invention provides a coating method for a tube-type PERC solar cell. Prior to the coating of the rear composite film, it is only required to pre-process the graphite boat with two steps (baking + coating of silicon carbide), without pre-coating the boat with a wafer inserted like the prior art. This greatly reduces the consumption of silicon wafers, prevents the silicon wafer from bending a lot due to a thick pre-coating on its surface, saves production time and enhances production efficiency. Moreover, during the process of coating the silicon carbide film, because there are a great many of fine graphite particles dispersed in the silicon carbide matrix, the silicon carbide matrix has an extreme small friction coefficient and exhibits a good self-lubricating property. On this account, when the silicon wafer is inserted into the graphite boat, there are fewer scratches on the silicon wafer, which greatly reduces the proportion of the EL scratches and increases the EL yield of the cell.

Furthermore, during the process of coating the rear composite film, the deposition temperature for silicon nitride is set to 390-410°C, and the deposition time is set within 100-400s, according to the present invention. By shortening the time and temperature of silicon nitride deposition, the bending of the silicon wafer can be reduced, and thus the amount of the undesirable coating can be reduced. The temperature window for silicon nitride deposition is very narrow, between 390-410 °C, which may allow the maximum reduction of the undesirable coating. When the deposition temperature is below 390°C, the amount of the undesirable coating increases, however.

### BRIEF DESCRIPTION OF THE DRAWINGS

FIG. 1 is a schematic diagram of a tubular PECVD device;
FIG. 2 is a schematic diagram of the graphite boat shown in FIG. 1;
FIG. 3 is a schematic diagram of a pin of the graphite boat shown in FIG. 2.

### DETAILED DESCRIPTION OF EMBODIMENTS

To more clearly illustrate the objectives, technical solutions and advantages of the present invention, the present invention will be further described in details with reference to the accompanying drawings.

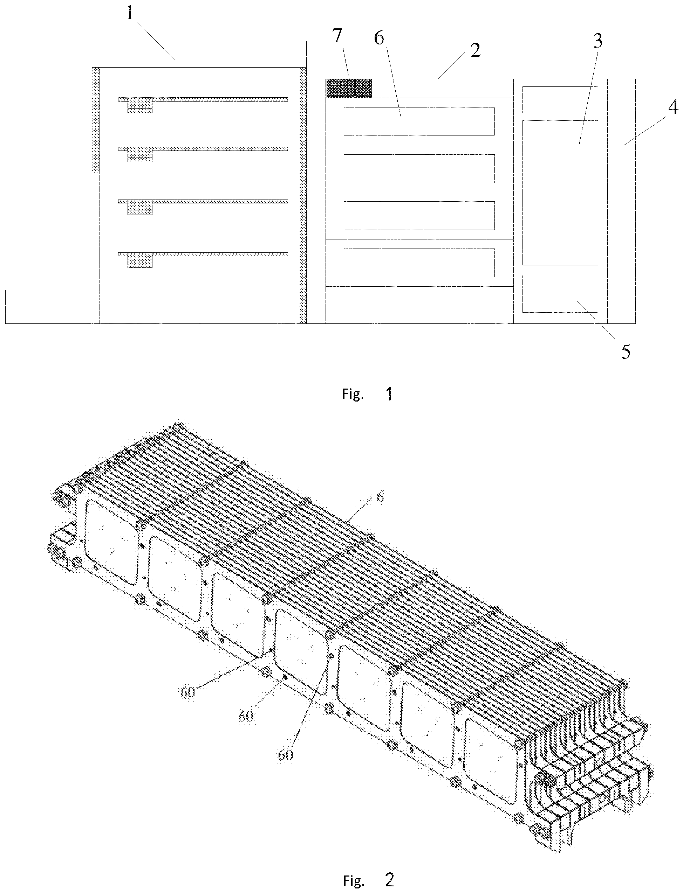

As shown in FIG. 1, the present invention provides a coating device for a tube-type PERC solar cell comprising a wafer loading area 1, a furnace body 2, a gas cabinet 3, a vacuum system 4, a heating system 7, a control system 5 and a graphite boat 6, wherein the gas cabinet is provided with a first gas line for feeding silane, a second gas line for feeding ammonia, a third gas line for feeding trimethylaluminum, a fourth gas line for feeding nitrous oxide and a fifth gas line for feeding methane; the first gas line, the second gas line, the third gas line, the fourth gas line and the fifth gas line are disposed inside the gas cabinet 3 and are not illustrated in FIG. 1.

The graphite boat 6 is used for loading and unloading a silicon wafer. The graphite boat 6 should be pre-processed before use or after several coating, wherein the pre-processing includes two steps: 1. baking the graphite boat; 2. coating the surface of the baked graphite boat with at least one layer of silicon carbide film.

A preferred implementation of pre-processing includes the following steps.
1. Placing the graphite boat in a tubular PECVD coating device for baking the graphite boat at a temperature of 300-480°C for 10-60min. Preferably, the baking temperature is 320-420°C and the time for baking is 20-50min. More preferably, the baking temperature is 350-400°C and the time for baking is 30-40min. Optimally, the baking temperature is 370-390°C and the time for baking is 32-35min. The purpose of baking is to remove water content from the graphite boat and prevent the moisture from reducing the passivation effects of aluminum oxide. The baking temperature is set between 300 and 480 °C to approach the temperature of the coating process and facilitate rapid switch of the coating device between pre-processing and normal production.
2. The graphite boat, after being baked and taken out, is placed in the tubular PECVD coating device again to coat the surface of the graphite boat with at least one layer of silicon carbide film, wherein the step of coating the silicon carbide film includes:
   Raising temperature to 380-480°C and feeding ammonia at a flow rate of 1-8slm for 2-10min with plasma power of 2000-5000w, to fully pre-heat the graphite boat;
   Feeding methane at a flow rate of 2-8slm and silane at a flow rate of 200-800sccm for 5-30s, so that a coating tube is filled therein with a certain proportion of process gas and prepares for plasma coating;
   Feeding methane at a flow rate of 2-8slm and silane at a flow rate of 200-800sccm for 1-4 hours with plasma power of 3000-10000w for plasma coating;
   Lowering the temperature to 350-400°C and taking out the boat.

In the step of coating silicon carbide film, an optimal effect of pre-processing the graphite boat may be achieved through the cooperation of the above various parameters with fewer materials, less time and boosted production efficiency.

A preferred implementation of coating the silicon carbide film contains:
Raising temperature to 400-460°C and feeding ammonia at a flow rate of 2-6slm for 3-8min with plasma power of 3000-4000w;
Feeding methane at a flow rate of 3-6slm and silane at a flow rate of 300-600sccm for 10-20s;
Feeding methane at a flow rate of 3-6slm and silane at a flow rate of 300-600sccm for 2-3 hours with plasma power of 5000-8000w;
Lowering the temperature to 370-390°C and taking out the boat.

Before use or after several coating, the graphite boat should be pre-processed, the pre-processing including baking the graphite boat by a heating system and coating the surface of the graphite boat with at least one layer of silicon carbide film by the gas cabinet. When the graphite boat is coated with the silicon carbide film, it is unnecessary to insert the silicon wafer into the boat. Because the silicon carbide is a semiconductor, the rear aluminum oxide coating has satisfactory uniformity, which reduces EL defects such as EL black zone and the like. The steps of pre-processing the graphite boat are decreased to two steps, i.e., baking and coating of silicon carbide, which saves time and enhances production efficiency. In addition, because there are a great many of fine graphite particles dispersed in the silicon carbide matrix, the silicon carbide matrix has an extreme small friction coefficient and exhibits a good self-lubricating property. On this account, when the silicon wafer is inserted into the graphite boat, there are fewer scratches on the silicon wafer, which greatly reduces the proportion of the EL scratches and increases the EL yield of the cell.

Therefore, with a simple structure, the coating device for the tube-type PERC solar cell simplifies the pre-processing steps of the graphite boat, reduces consumption of silicon wafers, avoids scratches on the silicon wafer and boosts the EL yield of the cell.

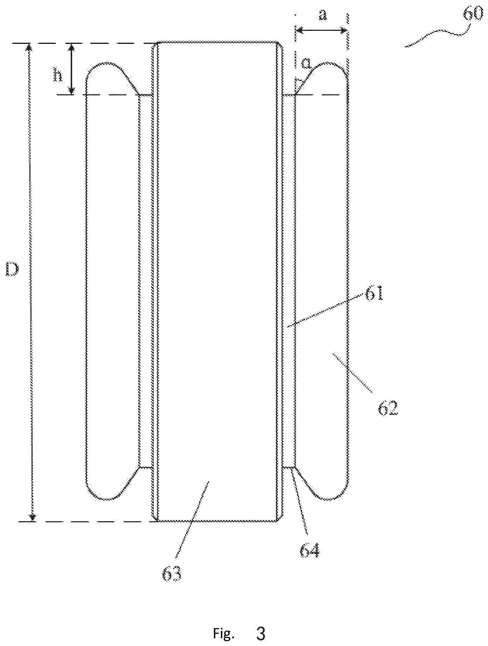

As shown in FIGS. 2 and 3, the graphite boat 6 is used for loading and unloading silicon wafers. The graphite boat 6 includes a pin 60 which includes a pin shaft 61, a pin cap 62, and a pin base 63. The pin shaft 61 is mounted on the pin base 63. The pin cap 62 is connected to the pin shaft 61. A pin slot 64 is formed among the pin shaft 61, the pin cap 62, and the pin base 63. The depth of the pin slot 64 is 0.5-1 mm.

As shown in FIG. 3, the depth of the pin slot 64, h, is preferably 0.6-0.8 mm; the diameter of the pin base 63, D, is preferably 6-15 mm; the angle of inclination of the inclination surface of the pin cap 62, α, is preferably 35-45 degrees; and the thickness of the pin cap 62, a, is preferably 1-1.3 mm.

More preferably, the depth of the pin slot 64 of the graphite boat, h, is 0.7-0.8mm; the diameter of the pin base 63, D, is 8-12mm; the angle of inclination of the inclined surface of the pin cap 62, α, is 37-42 degrees; and the thickness of the pin cap 62, a, is 1.1-1.2mm.

Optimally, the depth of the pin slot 64, h, is 0.7 mm; the diameter of the pin base 63, D, is 9 mm; the angle of inclination of the inclination surface of the pin cap 62, a, is 40 degrees; and the thickness of the pin cap 62, a, is 1.2 mm.

It should be noted that the depth h of the pin slot is the depth of the inside of the pin slot, and mainly refers to the depth of the side of the pin shaft 61 that forms an angle with the pin base 63. The depth h of the pin slot = (the diameter of the pin base - the diameter of the pin shaft) / 2. The angle of inclination of the inclination surface of the pin cap 62, α, refers to the angle between the inclination surface of the pin cap and the vertical direction.

In the prior art, the depth h of the pin slot is 1.75 mm, the diameter D of the pin base is 9 mm, the angle of inclination α of the inclination surface of the pin cap is 30 degrees, and the thickness a of the pin cap is 1 mm. In the prior art, the pin slot is deeper, which leads to a too big gap between the silicon wafer and the pin base at the position of the pin; and as a result, a lot of gas reaches and is coated on the rear surface of the silicon wafer, leading to the formation of a large number of boat teeth marks at the front surface edge of the cell. The pin cap has a small angle of inclination and a small thickness, leading to small adjustment room for the automatic wafer inserter; and consequentially, it is difficult to effectively lower the occurrence of scratching.

When employing tubular PECVD for rear film deposition, scratching and undesirable coating are contradictive. By adjusting an automatic wafer inserter, the silicon wafer can be inserted into the pin slot without contacting the graphite boat wall, during which the silicon wafer is kept at a distance from the graphite boat to avoid friction between the silicon wafer and the graphite boat wall. If the distance between the silicon wafer and the graphite boat plate were too large, scratching would be less likely to take place, but the possibility of the undesirable coating would increase as the silicon wafer would be less easy to be close to the boat wall. If the distance between the silicon wafer and the graphite boat plate were too larger further, the silicon wafer may be prevented from being inserted into the pin slot, and the silicon wafer may fall off as a result. If the distance between the silicon wafer and the graphite boat plate were too small, the silicon wafer would be closer to the graphite boat plate. As a result, undesirable coating would be less likely to take place, but the proportion of scratching would increase.

The position of the boat teeth mark at the edge of the front surface of the cell corresponds to the position of the pin during coating the rear surface by PECVD. The mark is formed as a result of gas flowing to the front surface of the cell from the position of the pin. Since the thickness of the pin base is slightly smaller than the thickness of the graphite boat plate, there is a gap between the silicon wafer and the pin base at the position of the pin. When coating the rear surface, the gas enters the gap from two sides below the pin shaft, which causes a film deposited at the front surface edge of the silicon wafer, i.e., forming a semi-circular boat teeth mark.

The present invention adjusts the diameter D of the pin base and the diameter of the pin shaft to reduce the depth h of the inside of the pin slot. As a result, the gap between the silicon wafer and the pin base at the position of the pin is reduced; consequentially, the amount of gas reaching and coating the rear surface of the silicon wafer is reduced, and boat teeth marks at the front surface edges are thus much less likely to occur.

By adjusting the automatic wafer inserter, after inserting the silicon wafer into a certain position in the graphite boat, the suction cup releases its vacuum and thus the silicon wafer falls onto the inclined surface α of the pin cap. As an effect of gravity, the silicon wafer slides down the inclined surface until it is close to the graphite boat wall. This type of insertion is contactless and could reduce scratching of the silicon wafer.

The present invention adequately increases the angle of inclination α of the inclined surface of the pin cap and the thickness a of the pin cap, and adjusts the automatic wafer inserter, thereby slightly increasing the distance between the silicon wafer and the graphite boat wall on inserting the wafer, reducing scratching. Increasing the angle of inclination of the inclined surface of the pin cap reduces the impact force on the silicon wafer from the graphite boat wall when the silicon wafer is sliding down, reducing breakage rate.

It should be noted that in the prior art, the problem of undesirable coating is typically tackled after the production is completed. For example, in the alkali polishing method during the production of PERC crystalline silicon solar cells disclosed in Chinese patent application No. 201510945459.3, after coating a silicon nitride film on the front surface by PECVD, the undesirable silicon nitride coating at the rear surface and the edges is removed by a belt-type transmission etching method, thereby solving the present problems of poor passivation at the rear surface due to undesirable coating formed during depositing the front film, and others. However, in the tube-type PERC cell of the present invention, undesirable coating takes place at the front surface during depositing the rear coating; and p-n junctions present at the front surface would be destroyed if the alkali polishing method of the above patent were used. By adjusting the coating process and the coating structure, the present invention can avoid undesirable coating during the production process and solve the problem of undesirable coating from its root. No additional process is required, which simplifies the overall process and reduces production cost. The invention is of great importance for the solar photovoltaic industry, which is extremely cost-sensitive. Moreover, the present invention also solves the problem of scratching.

Correspondingly, the present invention also discloses a coating method for a tube-type PERC solar cell, comprising:
(1) baking a graphite boat;
(2) coating at least one layer of silicon carbide film on a surface of the baked graphite boat;
(3) placing a processed silicon wafer on the graphite boat and sending the processed silicon wafer via the graphite boat into the tubular PECVD coating device, so as to form a rear composite film on the surface of the silicon wafer, wherein the rear composite film includes an aluminum oxide film, a silicon dioxide film, a silicon oxynitride film and a silicon nitride film.

As a preferred implementation of the coating method, the coating method includes:
(1) placing the graphite boat in the tubular PECVD coating device for baking the graphite boat at a temperature of 300-480°C for 10-60min;
(2) the graphite boat, after being baked and taken out, is placed in the tubular PECVD coating device again to coat the surface of the graphite boat with at least one layer of silicon carbide film, wherein the method of coating the silicon carbide film is as follows:
   raising temperature to 380-480°C and feeding ammonia at a flow rate of 1-8slm for 2-10min with plasma power of 2000-5000w;
   feeding methane at a flow rate of 2-8slm and silane at a flow rate of 200-800sccm for 5-30s;
   feeding methane at a flow rate of 2-8slm and silane at a flow rate of 200-800sccm for 1-4 hours with plasma power of 3000-10000w;
   lowering the temperature to 350-400°C and taking out the boat.
(3) placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 250-500 sccm, the ratio of TMA to N₂O is 1 to 15-25, and the plasma power is 2000-5000w;
   depositing a silicon oxynitride film using silane, ammonia, and nitrous oxide, wherein the gas flow rate of silane is 50-200 sccm, the ratio of silane to nitrous oxide is 1 to 10-80, the flow rate of ammonia is 0.1-5 slm, and the plasma power is 4000-6000w;
   depositing a silicon nitride film using silane and ammonia, wherein the gas flow rate of silane is 500-1000sccm, the ratio of silane to ammonia is 1 to 6-15, the deposition temperature of silicon nitride is 390-410 °C, the deposition time is 100-400s, and the plasma power is 10000-13000w; and
   depositing a silicon dioxide film using nitrous oxide, wherein the flow rate of nitrous oxide is 0.1-5 slm, and the plasma power is 2000-5000w.

As a more preferred implementation of the coating method, the coating method includes:
(1) placing the graphite boat in the tubular PECVD coating device for baking the graphite boat at a temperature of 320-420°C for 20-40min;
(2) the graphite boat, after being baked and taken out, is placed in the tubular PECVD coating device again to coat the surface of the graphite boat with at least one layer of silicon carbide film, wherein the method of coating the silicon carbide film is as follows:
   raising temperature to 400-460°C and feeding ammonia at a flow rate of 2-6slm for 3-8min with plasma power of 3000-4000w;
   feeding methane at a flow rate of 3-6slm and silane at a flow rate of 300-600sccm for 10-20s;
   feeding methane at a flow rate of 3-6slm and silane at a flow rate of 300-600sccm for 2-3 hours with plasma power of 5000-8000w;
   lowering the temperature to 370-390°C and taking out the boat.
(3) placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 250-500 sccm, the ratio of TMA to N₂O is 1 to 15-25, the deposition temperature of the aluminum oxide film is 250-300°C, the deposition time is 50-300s, and the plasma power is 2000-5000w;
   depositing a silicon oxynitride film using silane, ammonia, and nitrous oxide, wherein the gas flow rate of silane is 50-200 sccm, the ratio of silane to nitrous oxide is 1 to 10-80, the flow rate of ammonia is 0.1-5 slm, the deposition temperature of the silicon oxynitride film is 350-410 °C, the deposition time is 50-200s, and the plasma power is 4000-6000 w;
   depositing a silicon nitride film using silane and ammonia, wherein the gas flow rate of silane is 500-1000 sccm, the ratio of silane to ammonia is 1 to 6-15, the deposition temperature of the silicon nitride film is 390-410 °C, the deposition time is 100-400s, and the plasma power is 10000-13000w; and
   depositing a silicon dioxide film using nitrous oxide, wherein the flow rate of nitrous oxide is 0.1-5 slm, and the plasma power is 2000-5000 w.

The applicant discovered that undesirable coating mainly occurs during the deposition of silicon nitride. This is because silicon nitride is the outer (top) layer of the rear composite film; and as the deposition time increases, the thickness of the film at the surface of the silicon wafer increases, which causes the silicon wafer to bend. As a result, silane and ammonia are probably coated to the front surface edge of the cell. By shortening the time and temperature of silicon nitride deposition, the bending of the silicon wafer can be reduced, and thus the amount of the undesirable coating can be reduced. Further experiments have shown that the temperature window for silicon nitride deposition is very narrow, between 390-410 degrees; when the temperature is further lowered, the amount of the undesirable coating increases, however.

When depositing the aluminum oxide film, the plasma power is set to 2000-5000w; when depositing the silicon oxynitride film, the plasma power is set to 4000-6000w; when depositing the silicon nitride film, the plasma power is set to 10000-13000w; and when depositing the silicon dioxide film, the plasma power is set to 2000-5000w. This ensures that different layers have good deposition rates and improves deposition uniformity.

Therefore, the coating method for the tube-type PERC solar cell can simplify the pre-processing steps of the graphite boat, reduce consumption of silicon wafers, avoid scratches on the silicon wafer, reduce EL defects such as EL black zone and the like and enhance the EL yield of the cell.

The present invention is further elaborated below with reference to the specific embodiments.

### EMBODIMENT 1

(1) Placing the graphite boat in the tubular PECVD coating device for baking the graphite boat at a temperature of 300°C for 20min;
(2) The graphite boat, after being baked and taken out, is placed in the tubular PECVD coating device again to coat the surface of the graphite boat with at least one layer of silicon carbide film, wherein the method of coating the silicon carbide film is as follows:
   raising temperature to 380°C and feeding ammonia at a flow rate of 1slm for 2min with plasma power of 2000w;
   feeding methane at a flow rate of 2slm and silane at a flow rate of 200sccm for 5s;
   feeding methane at a flow rate of 2slm and silane at a flow rate of 200sccm for 1 hour with plasma power of 3000w;
   lowering the temperature to 350°C and taking out the boat.
(3) Placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 250 sccm, the ratio of TMA to N₂O is 1 to 15, the deposition temperature of the aluminum oxide film is 250 °C, the time is 50s, and the plasma power is 2000w;
   depositing a silicon oxynitride film using silane, ammonia, and nitrous oxide, wherein the gas flow rate of silane is 50 sccm, the ratio of silane to nitrous oxide is 1 to 10, the flow rate of ammonia is 0.1 slm, the deposition temperature of the silicon oxynitride film is 350°C, the time is 50s, and the plasma power is 4000w;
   depositing a silicon nitride film using silane and ammonia, wherein the gas flow rate of silane is 500 sccm, the ratio of silane to ammonia is 1 to 6, the deposition temperature of the silicon nitride film is 390°C, the time is 100s, and the plasma power is 10000w; and
   depositing a silicon dioxide film using nitrous oxide, wherein the flow rate of nitrous oxide is 0.1 slm, and the plasma power is 2000w.

### EMBODIMENT 2

(1) Placing the graphite boat in the tubular PECVD coating device for baking the graphite boat at a temperature of 350°C for 25min;
(2) The graphite boat, after being baked and taken out, is placed in the tubular PECVD coating device again to coat the surface of the graphite boat with at least one layer of silicon carbide film, wherein the method of coating the silicon carbide film is as follows:
   raising temperature to 400°C and feeding ammonia at a flow rate of 2slm for 3min with plasma power of 3000w;
   feeding methane at a flow rate of 4slm and silane at a flow rate of 400sccm for 10s;
   feeding methane at a flow rate of 3slm and silane at a flow rate of 300sccm for 2 hours with plasma power of 5000w;
   lowering the temperature to 360°C and taking out the boat.
(3) Placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 300 sccm, the ratio of TMA to N₂O is 1 to 18, the deposition temperature of the aluminum oxide film is 260°C, the time is 80s, and the plasma power is 2500w;
   depositing a silicon oxynitride film using silane, ammonia, and nitrous oxide, wherein the gas flow rate of silane is 80 sccm, the ratio of silane to nitrous oxide is 1 to 20, the flow rate of ammonia is 1 slm, the deposition temperature of the silicon oxynitride film is 360°C, the time is 100s, and the plasma power is 4500w;
   depositing a silicon nitride film using silane and ammonia, wherein the gas flow rate of silane is 600 sccm, the ratio of silane to ammonia is 1 to 8, the deposition temperature of the silicon nitride film is 395°C, the time is 150s, and the plasma power is 10000w; and
   depositing a silicon dioxide film using nitrous oxide, wherein the flow rate of nitrous oxide is 1 slm, and the plasma power is 2500w.

### EMBODIMENT 3

(1) Placing the graphite boat in the tubular PECVD coating device for baking the graphite boat at a temperature of 370°C for 30min;
(2) The graphite boat, after being baked and taken out, is placed in the tubular PECVD coating device again to coat the surface of the graphite boat with at least one layer of silicon carbide film, wherein the method of coating the silicon carbide film is as follows:
   raising temperature to 420°C and feeding ammonia at a flow rate of 5slm for 5min with plasma power of 4000w;
   feeding methane at a flow rate of 5slm and silane at a flow rate of 500sccm for 15s;
   feeding methane at a flow rate of 4slm and silane at a flow rate of 500sccm for 1.5 hours with plasma power of 6000w;
   lowering the temperature to 380°C and taking out the boat.
(3) Placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 350 sccm, the ratio of TMA to N₂O is 1 to 22, the deposition temperature of the aluminum oxide film is 280°C, the time is 150s, and the plasma power is 3500w;
   depositing a silicon oxynitride film using silane, ammonia, and nitrous oxide, wherein the gas flow rate of silane is 180 sccm, the ratio of silane to nitrous oxide is 1 to 40, the flow rate of ammonia is 3 slm, the deposition temperature of the silicon oxynitride film is 380°C, the time is 150s, and the plasma power is 5000w;
   depositing a silicon nitride film using silane and ammonia, wherein the gas flow rate of silane is 800 sccm, the ratio of silane to ammonia is 1 to 10, the deposition temperature of the silicon nitride film is 405°C, the time is 300s, and the plasma power is 12000w; and
   depositing a silicon dioxide film using nitrous oxide, wherein the flow rate of nitrous oxide is 4 slm, and the plasma power is 4000w.

### EMBODIMENT 4

(1) Placing the graphite boat in the tubular PECVD coating device for baking the graphite boat at a temperature of 400°C for 35min;
(2) The graphite boat, after being baked and taken out, is placed in the tubular PECVD coating device again to coat the surface of the graphite boat with at least one layer of silicon carbide film, wherein the method of coating the silicon carbide film is as follows:
   raising temperature to 450°C and feeding ammonia at a flow rate of 6slm for 8min with plasma power of 4000w;
   feeding methane at a flow rate of 6slm and silane at a flow rate of 500sccm for 20s;
   feeding methane at a flow rate of 6slm and silane at a flow rate of 500sccm for 1 hour with plasma power of 8000w;
   lowering the temperature to 390°C and taking out the boat.
(3) Placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 400 sccm, the ratio of TMA to N₂O is 1 to 20, the deposition temperature of the aluminum oxide film is 280°C, the time is 250s, and the plasma power is 4500w;
   depositing a silicon oxynitride film using silane, ammonia, and nitrous oxide, wherein the gas flow rate of silane is 180 sccm, the ratio of silane to nitrous oxide is 1 to 60, the flow rate of ammonia is 4 slm, the deposition temperature of the silicon oxynitride film is 400°C, the time is 180s, and the plasma power is 5500w;
   depositing a silicon nitride film using silane and ammonia, wherein the gas flow rate of silane is 900 sccm, the ratio of silane to ammonia is 1 to 14, the deposition temperature of the silicon nitride film is 400°C, the time is 300s, and the plasma power is 13000w; and
   depositing a silicon dioxide film using nitrous oxide, wherein the flow rate of nitrous oxide is 4 slm, and the plasma power is 4000w.

### EMBODIMENT 5

(1) Placing the graphite boat in the tubular PECVD coating device for baking the graphite boat at a temperature of 420°C for 30min;
(2) The graphite boat, after being baked and taken out, is placed in the tubular PECVD coating device again to coat the surface of the graphite boat with at least one layer of silicon carbide film, wherein the method of coating the silicon carbide film is as follows:
   raising temperature to 480°C and feeding ammonia at a flow rate of 8slm for 10min with plasma power of 5000w;
   feeding methane at a flow rate of 8slm and silane at a flow rate of 800sccm for 30s;
   feeding methane at a flow rate of 8slm and silane at a flow rate of 800sccm for 1 hour with plasma power of 10000w;
   lowering the temperature to 400°C and taking out the boat.
(3) Placing a processed silicon wafer on the graphite boat and sending the processed silicon wafer via the graphite boat into the tubular PECVD coating device to form a rear composite film, wherein the method of coating the rear composite film is as follows:
   depositing an aluminum oxide film using TMA and N₂O, wherein the gas flow rate of TMA is 500 sccm, the ratio of TMA to N₂O is 1 to 25, the deposition temperature of the aluminum oxide film is 300°C, the time is 300s, and the plasma power is 5000w;
   depositing a silicon oxynitride film using silane, ammonia, and nitrous oxide, wherein the gas flow rate of silane is 200 sccm, the ratio of silane to nitrous oxide is 1 to 80, the flow rate of ammonia is 5 slm, the deposition temperature of the silicon oxynitride film is 410°C, the time is 200s, and the plasma power is 6000w;
   depositing a silicon nitride film using silane and ammonia, wherein the gas flow rate of silane is 1000 sccm, the ratio of silane to ammonia is 1 to 15, the deposition temperature of the silicon nitride film is 410°C, the time is 400s, and the plasma power is 13000w; and
   depositing a silicon dioxide film using nitrous oxide, wherein the flow rate of nitrous oxide is 5 slm, and the plasma power is 5000w.

Technical test for the coating methods according to embodiments 1-5 are presented below:

| Item | Consumption of silicon wafers | Scratching rate of silicon wafer | EL yield | Preprocessing time for graphite boat |
|---|---|---|---|---|
| Prior Art | 280 slices per boat | 5-10% | 20-60% | 3-6h |
| Embodiment 1 | 0 | 1-4% | 80-90% | around 82 min |
| Embodiment 2 | 0 | 1-3% | 85-90% | around 148 min |
| Embodiment 3 | 0 | 1-2.5% | 90-95% | around 125 min |
| Embodiment 4 | 0 | 0.5-3.5% | 95-97% | around 103 min |
| Embodiment 5 | 0 | 0.5-2% | 95-98% | around 100 min |

To sum up, implementation of the present invention achieves following advantageous effects:
I. The present invention provides a coating device for a tube-type PERC solar cell comprising a heating system and a gas cabinet, wherein the gas cabinet is provided with a first gas line for feeding silane, a second gas line for feeding ammonia, a third gas line for feeding trimethylaluminum, a fourth gas line for feeding nitrous oxide and a fifth gas line for feeding methane. Before use or after several coating, the graphite boat should be pre-processed. Specifically, the graphite boat is baked by a heating system and the surface of the graphite boat is coated with at least one layer of silicon carbide film by the gas cabinet. When the graphite boat is coated with the silicon carbide film, it is unnecessary to insert the silicon wafer into the boat. Because the silicon carbide is a semiconductor, the rear aluminum oxide coating has satisfactory uniformity. The steps of pre-processing the graphite boat are decreased to two steps, i.e., baking and coating of silicon carbide, which saves time and enhances production efficiency. In addition, because there are a great many of fine graphite particles dispersed in the silicon carbide matrix, the silicon carbide matrix has an extreme small friction coefficient and exhibits a good self-lubricating property. On this account, when the silicon wafer is inserted into the graphite boat, there are fewer scratches on the silicon wafer, which greatly reduces the proportion of the EL scratches and increases the EL yield of the cell.

Furthermore, the present invention adjusts the diameters of the pin shaft and the pin base to reduce the depth of the inside of the pin slot. As a result, the gap between the silicon wafer and the pin base at the position of the pin is reduced. Further, the amount of gas reaching and coating the rear surface of the silicon wafer is reduced, and boat teeth marks at the front surface edges of the cell thus are much less likely to occur. In addition, the present invention adequately increases the angle of inclination of the inclined surface of the pin cap and the thickness of the pin cap, and adjusts the automatic wafer inserter, thereby slightly increasing the distance between the silicon wafer and the graphite boat wall on inserting the wafer, and reducing scratching. Meanwhile, it is possible to reduce the impact force on the silicon wafer from the graphite boat wall when the silicon wafer is sliding down, reducing breakage rate.

II. The present invention provides a coating method for a tube-type PERC solar cell. Prior to the coating of the rear composite film, it is only required to pre-process the graphite boat with two steps (baking + coating of silicon carbide), without coating the boat with a wafer inserted like the prior art. This greatly reduces the consumption of silicon wafers, prevents the silicon wafer from bending a lot due to a thick coating on its surface, saves production time and enhances production efficiency. Moreover, during the process of coating the silicon carbide film, because there are a great many of fine graphite particles dispersed in the silicon carbide matrix, the silicon carbide matrix has an extreme small friction coefficient and exhibits a good self-lubricating property. On this account, when the silicon wafer is inserted into the graphite boat, there are fewer scratches on the silicon wafer, which greatly reduces the proportion of the EL scratches and increases the EL yield of the cell.

Furthermore, during the process of coating the rear composite film, the deposition temperature for silicon nitride is set to 390-410°C, and the deposition time is set within 100-400s, according to the present invention. By shortening the time and temperature of silicon nitride deposition, the bending of the silicon wafer can be reduced, and thus the amount of the undesirable coating can be reduced. The temperature window for silicon nitride deposition is very narrow, between 390-410 °C, which may allow the maximum reduction of the undesirable coating. When the deposition temperature is below 390°C, the amount of the undesirable coating increases, however.

Finally, it should be noted that the above embodiments are only intended to illustrate the technical solutions of the present invention and are not intended to limit the scope of the present invention.

## Claims

1. A coating method for a tube-type PERC solar cell, **characterized in** comprising:
(1) placing a graphite boat (6) in a tubular PECVD coating device for baking the graphite boat at a temperature of 300-480°C for 10-60min;
(2) placing the graphite boat, which has been baked and taken out, in the tubular PECVD coating device again to coat a surface of the graphite boat with at least one layer of silicon carbide film; and
(3) placing a processed silicon wafer on the graphite boat and sending the processed silicon wafer via the graphite boat into the tubular PECVD coating device, so as to form a rear composite film on a surface of the silicon wafer, wherein the rear composite film includes an aluminum oxide film, a silicon dioxide film, a silicon oxynitride film and a silicon nitride film.

2. A coating method according to claim 1 for a tube-type PERC solar cell, **characterized by**:
(1) placing the graphite boat in the tubular PECVD coating device for baking the graphite boat at a temperature of 300-480°C for 10-60min;
(2) placing the graphite boat, which has been baked and taken out, in the tubular PECVD coating device again to coat the surface of the graphite boat with the at least one layer of silicon carbide film, wherein a method of coating the silicon carbide film includes:
raising temperature to 380-480°C and feeding ammonia at a flow rate of 1-8slm for 2-10min with plasma power of 2000-5000W;
feeding methane at a flow rate of 2-8slm and silane at a flow rate of 200-800sccm for 5-30s;
feeding methane at a flow rate of 2-8slm and silane at a flow rate of 200-800sccm for 1-4 hours with plasma power of 3000-10000W; and
lowering the temperature to 350-400°C and taking out the graphite boat; and
(3) placing the processed silicon wafer on the graphite boat and sending the processed silicon wafer via the graphite boat into the tubular PECVD coating device to form the rear composite film, wherein a method of coating the rear composite film includes:
depositing the aluminum oxide film using TMA and N₂O, wherein a gas flow rate of TMA is 250-500 sccm, a ratio of TMA to N₂O is 1 to 15-25, and plasma power is 2000-5000W;
depositing the silicon oxynitride film using silane, ammonia, and nitrous oxide, wherein a gas flow rate of silane is 50-200 sccm, a ratio of silane to nitrous oxide is 1 to 10-80, a flow rate of ammonia is 0.1-5 slm, and plasma power is 4000-6000W;
depositing the silicon nitride film using silane and ammonia, wherein the gas flow rate of silane is 500-1000 sccm, a ratio of silane to ammonia is 1 to 6-15, a deposition temperature of silicon nitride is 390-410 °C, a deposition time is 100-400s, and plasma power is 10000-13000W; and
depositing the silicon dioxide film using nitrous oxide, wherein a flow rate of nitrous oxide is 0.1-5 slm, and plasma power is 2000-5000W.

3. A coating method according to claim 2 for a tube-type PERC solar cell **characterized by**:
(1) placing the graphite boat in the tubular PECVD coating device for baking the graphite boat at a temperature of 320-420°C for 20-40min;
(2) placing the graphite boat, which has been baked and taken out, in the tubular PECVD coating device again to coat the surface of the graphite boat with the at least one layer of silicon carbide film, wherein a method of coating the silicon carbide film includes:
raising temperature to 400-460°C and feeding ammonia at a flow rate of 2-6slm for 3-8min with plasma power of 3000-4000W;
feeding methane at a flow rate of 3-6slm and silane at a flow rate of 300-600sccm for 10-20s;
feeding methane at a flow rate of 3-6slm and silane at a flow rate of 300-600sccm for 2-3 hours with plasma power of 5000-8000W; and
lowering the temperature to 370-390°C and taking out the graphite boat; and
(3) placing a processed silicon wafer on the graphite boat and sending the processed silicon wafer via the graphite boat into the tubular PECVD coating device to form the rear composite film, wherein a method of coating the rear composite film includes:
depositing the aluminum oxide film using TMA and N₂O, wherein a gas flow rate of TMA is 250-500 sccm, a ratio of TMA to N₂O is 1 to 15-25, a deposition temperature of the aluminum oxide film is 250-300 °C, a deposition time is 50-300s, and plasma power is 2000-5000W;
depositing the silicon oxynitride film using silane, ammonia, and nitrous oxide, wherein a gas flow rate of silane is 50-200 sccm, a ratio of silane to nitrous oxide is 1 to 10-80, a flow rate of ammonia is 0.1-5 slm, a deposition temperature of the silicon oxynitride film is 350-410 °C, a deposition time is 50-200s, and plasma power is 4000-6000W;
depositing the silicon nitride film using silane and ammonia, wherein a gas flow rate of silane is 500-1000 sccm, a ratio of silane to ammonia is 1 to 6-15, a deposition temperature of the silicon nitride film is 390-410 °C, a deposition time is 100-400s, and plasma power is 10000-13000W; and
depositing the silicon dioxide film using nitrous oxide, wherein a flow rate of nitrous oxide is 0.1-5 slm, and plasma power is 2000-5000W.

4. The coating method according to claim 1 for a tube-type PERC solar cell, wherein the graphite boat includes a pin which includes a pin shaft, a pin cap, and a pin base; the pin shaft is mounted on the pin base; the pin cap is connected to the pin shaft; a pin slot is formed among the pin shaft, the pin cap, and the pin base; and a depth of the pin slot is 0.5-1mm.

5. The coating method according to claim 4 for a tube-type PERC solar cell wherein the pin slot of the graphite boat has the depth of 0.6-0.8 mm, a diameter of the pin base is 6-15 mm, an angle of inclination of an inclined surface of the pin cap is 35-45 degrees, and a thickness of the pin cap is 1-1.3 mm.

6. The coating method according to claim 5 for a tube-type PERC solar cell wherein the pin slot of the graphite boat has the depth of 0.7-0.8mm, the diameter of the pin base is 8-12mm, the angle of inclination of the inclined surface of the pin cap is 37-42 degrees, and the thickness of the pin cap is 1.1-1.2mm.

## Patentansprüche

1. Beschichtungsverfahren für eine röhrenförmige PERC-Solarzelle, **dadurch gekennzeichnet, dass** es umfasst:
(1) Einsetzen eines Graphitschiffchens (6) in eine röhrenförmige PECVD-Beschichtungsvorrichtung zum Backen des Graphitschiffchens bei einer Temperatur von 300-480°C für 10-60 Minuten;
(2) erneutes Einsetzen des gebackenen und entnommenen Graphitschiffchens in die röhrenförmige PECVD-Beschichtungsvorrichtung, um eine Oberfläche des Graphitschiffchens mit mindestens einer Schicht aus Siliciumcarbid zu beschichten; und
(3) Platzieren eines bearbeiteten Siliziumwafers auf dem Graphitschiffchen und Einführen des bearbeiteten Siliziumwafers über das Graphitschiffchen in die röhrenförmige PECVD-Beschichtungsvorrichtung, um einen rückwärtigen Verbundfilm auf einer Oberfläche des Siliziumwafers zu bilden, wobei der rückwärtige Verbundfilm einen Aluminiumoxidfilm, einen Siliziumdioxidfilm, einen Siliziumoxynitridfilm und einen Siliziumnitridfilm umfasst.

2. Beschichtungsverfahren nach Anspruch 1 für eine rohrförmigen PERC-Solarzelle, **gekennzeichnet durch**:
(1) Einsetzen des Graphitschiffchens in die röhrenförmige PECVD-Beschichtungsvorrichtung zum Backen des Graphitschiffchens bei einer Temperatur von 300-480°C für 10-60 Minuten;
(2) erneutes Einsetzen des gebackenen und entnommenen Graphitschiffchens in die röhrenförmige PECVD-Beschichtungsvorrichtung, um die Oberfläche des Graphitschiffchens mit der mindestens einen Schicht aus Siliciumcarbidfilm zu beschichten, wobei ein Verfahren zum Beschichten des Siliciumcarbidfilms umfasst:
Erhöhen der Temperatur auf 380-480°C und Zuführen von Ammoniak mit einer Durchflussrate von 1-8 slm für 2-10 min bei einer Plasmaleistung von 2000-5000 W;
Zuführen von Methan mit einer Durchflussrate von 2-8 slm und Silan mit einer Durchflussrate von 200-800 sccm für 5-30 s;
Zuführen von Methan mit einer Durchflussrate von 2-8 slm und Silan mit einer Durchflussrate von 200-800 sccm für 1-4 Stunden bei einer Plasmaleistung von 3000-10000 W; und
Absenken der Temperatur auf 350-400°C und Entnehmen des Graphitschiffchens; und
(3) Platzieren des bearbeiteten Siliziumwafers auf dem Graphitschiffchen und Einführen des bearbeiteten Siliziumwafers über das Graphitschiffchen in die röhrenförmige PECVD-Beschichtungsvorrichtung, um den hinteren Verbundfilm zu bilden, wobei ein Verfahren zum Beschichten des hinteren Verbundfilms umfasst:
Abscheiden des Aluminiumoxidfilms unter Verwendung von TMA und N₂O, wobei die Gasflussrate von TMA 250-500 sccm, das Verhältnis von TMA zu N₂O 1 zu 15-25 und die Plasmaleistung 2000-5000 W beträgt;
Abscheiden des Siliziumoxynitridfilms unter Verwendung von Silan, Ammoniak und Distickstoffoxid, wobei die Gasdurchflussrate von Silan 50-200 sccm, das Verhältnis von Silan zu Distickstoffoxid 1 zu 10-80, die Durchflussrate von Ammoniak 0,1-5 slm und die Plasmaleistung 4000-6000 W beträgt;
Abscheiden des Siliziumnitridfilms unter Verwendung von Silan und Ammoniak, wobei die Gasflussrate von Silan 500-1000 sccm beträgt, ein Verhältnis von Silan zu Ammoniak 1 zu 6-15 ist, eine Abscheidungstemperatur von Siliziumnitrid 390-410 °C ist, eine Abscheidungszeit 100-400 s ist und die Plasmaleistung 10000-13000 W ist; und
Abscheiden des Siliziumdioxidfilms unter Verwendung von Distickstoffoxid, wobei die Durchflussrate des Distickstoffoxids 0,1-5 slm und die Plasmaleistung 2000-5000 W beträgt.

3. Beschichtungsverfahren nach Anspruch 2 für eine röhrenförmige PERC-Solarzelle, **gekennzeichnet durch**:
(1) Einsetzen des Graphitschiffchens in die röhrenförmige PECVD-Beschichtungsvorrichtung zum Backen des Graphitschiffchens bei einer Temperatur von 320-420°C für 20-40 Minuten;
(2) erneutes Einsetzen des gebackenen und entnommenen Graphitschiffchens in die röhrenförmige PECVD-Beschichtungsvorrichtung, um die Oberfläche des Graphitschiffchens mit der mindestens einen Schicht aus Siliciumcarbidfilm zu beschichten, wobei ein Verfahren zum Beschichten des Siliciumcarbidfilms umfasst:
Erhöhen der Temperatur auf 400-460°C und Zuführen von Ammoniak mit einer Durchflussrate von 2-6 slm für 3-8 min bei einer Plasmaleistung von 3000-4000 W;
Zuführen von Methan mit einer Durchflussrate von 3-6 slm und Silan mit einer Durchflussrate von 300-600 sccm für 10-20 s;
Zuführen von Methan mit einer Durchflussrate von 3-6 slm und Silan mit einer Durchflussrate von 300-600 sccm für 2-3 Stunden bei einer Plasmaleistung von 5000-8000 W; und
Absenkeng der Temperatur auf 370-390°C und Entnehmen des Graphitschiffchens; und
(3) Platzieren eines bearbeiteten Siliziumwafers auf dem Graphitschiffchen und Senden des bearbeiteten Siliziumwafers über das Graphitschiffchen in die röhrenförmige PECVD-Beschichtungsvorrichtung, um den hinteren Verbundfilm zu bilden, wobei ein Verfahren zum Beschichten des hinteren Verbundfilms umfasst:
Abscheiden des Aluminiumoxidfilms unter Verwendung von TMA und N₂O, wobei die Gasflussrate von TMA 250-500 sccm beträgt, das Verhältnis von TMA zu N₂O 1 bis 15-25 beträgt, die Abscheidungstemperatur des Aluminiumoxidfilms 250-300 °C beträgt, die Abscheidungszeit 50-300 s beträgt und die Plasmaleistung 2000-5000 W beträgt;
Abscheiden des Siliciumoxynitridfilms unter Verwendung von Silan, Ammoniak und Distickstoffoxid, wobei die Gasdurchflussrate von Silan 50-200 sccm, das Verhältnis von Silan zu Distickstoffoxid 1 zu 10-80, die Durchflussrate von Ammoniak 0,1-5 slm, die Abscheidungstemperatur des Siliciumoxynitridfilms 350-410 °C, die Abscheidungszeit 50-200 s und die Plasmaleistung 4000-6000 W beträgt;
Abscheiden des Siliciumnitridfilms unter Verwendung von Silan und Ammoniak, wobei eine Gasflussrate von Silan 500-1000 sccm beträgt, ein Verhältnis von Silan zu Ammoniak 1 zu 6-15 beträgt, eine Abscheidungstemperatur des Siliciumnitridfilms 390-410 °C beträgt, eine Abscheidungszeit 100-400 s beträgt und die Plasmaleistung 10000-13000 W beträgt; und
Abscheiden des Siliziumdioxidfilms unter Verwendung von Distickstoffoxid, wobei die Durchflussrate des Distickstoffoxids 0,1-5 slm und die Plasmaleistung 2000-5000 W beträgt.

4. Beschichtungsverfahren nach Anspruch 1 für eine röhrenförmige PERC-Solarzelle, wobei das Graphitschiffchen einen Stift enthält, der einen Stiftschaft, eine Stiftkappe und eine Stiftbasis aufweist; der Stiftschaft auf der Stiftbasis montiert ist; die Stiftkappe mit dem Stiftschaft verbunden ist; ein Stiftschlitz zwischen dem Stiftschaft, der Stiftkappe und der Stiftbasis ausgebildet ist; und eine Tiefe des Stiftschlitzes 0,5-1 mm beträgt.

5. Beschichtungsverfahren nach Anspruch 4 für eine röhrenförmige PERC-Solarzelle, wobei der Stiftschlitz des Graphitschiffchens eine Tiefe von 0,6-0,8 mm hat, ein Durchmesser der Stiftbasis 6-15 mm beträgt, ein Neigungswinkel einer geneigten Oberfläche der Stiftkappe 35-45 Grad beträgt und eine Dicke der Stiftkappe 1-1,3 mm beträgt.

6. Beschichtungsverfahren nach Anspruch 5 für eine röhrenförmige PERC-Solarzelle, wobei der Stiftschlitz des Graphitschiffchens eine Tiefe von 0,7-0,8 mm hat, der Durchmesser der Stiftbasis 8-12 mm beträgt, der Neigungswinkel der geneigten Oberfläche der Stiftkappe 37-42 Grad beträgt und die Dicke der Stiftkappe 1,1-1,2 mm beträgt.

## Revendications

1. Méthode de revêtement d'une cellule solaire PERC de type tubulaire, **caractérisée par le fait qu'**elle comprend :
(1) placer une barquette de graphite (6) dans un dispositif de revêtement PECVD tubulaire pour cuire la barquette de graphite à une température de 300-480°C pendant 10-60 minutes ;
(2) placer le bateau en graphite, qui a été cuit et retiré, dans le dispositif de revêtement PECVD tubulaire afin de recouvrir une surface du bateau en graphite avec au moins une couche de film de carbure de silicium ; et
(3) placer une plaquette de silicium traitée sur le bateau en graphite et s terminer la plaquette de silicium traitée via le bateau en graphite dans le dispositif de revêtement PECVD tubulaire, de manière à former un film composite arrière sur une surface de la plaquette de silicium, le film composite arrière comprenant un film d'oxyde d'aluminium, un film de dioxyde de silicium, un film d'oxynitrure de silicium et un film de nitrure de silicium.

2. Méthode de revêtement selon la revendication 1 pour une cellule solaire PERC de type tube, **caractérisée par** :
(1) placer la barquette de graphite dans le dispositif de revêtement PECVD tubulaire pour la cuire à une température de 300 à 480 °C pendant 10 à 60 minutes ;
(2) placer le bateau en graphite, qui a été cuit et retiré, dans le dispositif de revêtement PECVD tubulaire pour recouvrir la surface du bateau en graphite avec au moins une couche de film de carbure de silicium, dans lequel une méthode de revêtement du film de carbure de silicium comprend :
augmenter de la température à 380-480°C et alimenter en ammoniac à un débit de 1-8slm pendant 2-10min avec une puissance de plasma de 2000-5000W ;
alimenter en méthane à un débit de 2-8slm et en silane à un débit de 200-800sccm pendant 5-30s ;
alimenter en méthane à un débit de 2-8slm et en silane à un débit de 200-800sccm pendant 1-4 heures avec une puissance de plasma de 3000-10000W ; et
abaisser la température à 350-400°C et retirer la barquette de graphite ; et
(3) placer la plaquette de silicium traitée sur le bateau en graphite et envoyer la plaquette de silicium traitée via le bateau en graphite dans le dispositif de revêtement PECVD tubulaire pour former le film composite arrière, dans lequel une méthode de revêtement du film composite arrière comprend :
déposer du film d'oxyde d'aluminium à l'aide de TMA et de N₂ O, dans lequel un débit de gaz de TMA est de 250-500 sccm, un rapport de TMA à N₂ O est de 1 à 15-25, et la puissance du plasma est de 2000-5000W ;
déposer du film d'oxynitrure de silicium à l'aide de silane, d'ammoniac et d'oxyde nitreux, le débit de gaz du silane étant de 50 à 200 sccm, le rapport silane/oxyde nitreux de 1 à 10-80, le débit d'ammoniac de 0,1 à 5 slm et la puissance du plasma de 4 000 à 6 000 W ;
déposer du film de nitrure de silicium à l'aide de silane et d'ammoniac, dans lequel le débit de silane est de 500-1000 sccm, le rapport silane/ammoniac est de 1 à 6-15, la température de déposer du nitrure de silicium est de 390-410 °C, le temps de déposer est de 100-400s et la puissance du plasma est de 10000-13000W ; et
déposer du film de dioxyde de silicium à l'aide d'oxyde nitreux, le débit d'oxyde nitreux étant de 0,1 à 5 slm et la puissance du plasma de 2000 à 5000 W.

3. Méthode de revêtement selon la revendication 2 pour une cellule solaire PERC de type tube, **caractérisée par** :
(1) placer la barquette de graphite dans le dispositif de revêtement PECVD tubulaire pour la cuire à une température de 320-420°C pendant 20-40 minutes ;
(2) placer le bateau en graphite, qui a été cuit et retiré, dans le dispositif de revêtement PECVD tubulaire pour recouvrir la surface du bateau en graphite avec au moins une couche de film de carbure de silicium, dans lequel une méthode de revêtement du film de carbure de silicium comprend :
augmenter de la température à 400-460°C et alimenter en ammoniac à un débit de 2-6slm pendant 3-8min avec une puissance de plasma de 3000-4000W ;
alimenter en méthane à un débit de 3-6slm et en silane à un débit de 300-600sccm pendant 10-20s ;
alimenter en méthane à un débit de 3-6slm et en silane à un débit de 300-600sccm pendant 2-3 heures avec une puissance de plasma de 5000-8000W ; et
abaisser la température à 370-390°C et retirer la barque de graphite ; et
(3) placer une plaquette de silicium traitée sur le bateau en graphite et envoyer la plaquette de silicium traitée via le bateau en graphite dans le dispositif de revêtement PECVD tubulaire pour former le film composite arrière, dans lequel une méthode de revêtement du film composite arrière comprend :
déposer du film d'oxyde d'aluminium à l'aide de TMA et de N₂ O, dans lequel un débit de gaz de TMA est de 250-500 sccm, un rapport de TMA à N₂ O est de 1 à 15-25, une température de déposer du film d'oxyde d'aluminium est de 250-300 °C, un temps de déposer est de 50-300s, et la puissance du plasma est de 2000-5000W ;
déposer du film d'oxynitrure de silicium en utilisant du silane, de l'ammoniac et de l'oxyde nitreux, dans lequel un débit de gaz de silane est de 50-200 sccm, un rapport de silane à l'oxyde nitreux est de 1 à 10-80, un débit d'ammoniac est de 0,1-5 slm, une température de déposer du film d'oxynitrure de silicium est de 350-410 °C, un temps de déposer est de 50-200s, et la puissance du plasma est de 4000-6000W ;
déposer du film de nitrure de silicium à l'aide de silane et d'ammoniac, dans lequel un débit de gaz de silane est de 500-1000 sccm, un rapport de silane à ammoniac est de 1 à 6-15, une température de déposer du film de nitrure de silicium est de 390-410 °C, un temps de déposer est de 100-400s, et la puissance du plasma est de 10000-13000W ; et
déposer du film de dioxyde de silicium à l'aide d'oxyde nitreux, le débit d'oxyde nitreux étant de 0,1 à 5 slm et la puissance du plasma de 2000 à 5000 W.

4. La méthode de revêtement selon la revendication 1 pour une cellule solaire PERC de type tube, dans laquelle le bateau en graphite comprend une broche qui comprend une tige de broche, un capuchon de broche et une base de broche ; la tige de broche est montée sur la base de broche ; le capuchon de broche est connecté à la tige de broche ; une fente de broche est formée entre la tige de broche, le capuchon de broche et la base de broche ; et une profondeur de la fente de broche est de 0,5 à 1 mm.

5. Méthode de revêtement selon la revendication 4 pour une cellule solaire PERC de type tube, dans laquelle la fente du bateau en graphite a une profondeur de 0,6 à 0,8 mm, un diamètre de la base de la broche de 6 à 15 mm, un angle d'inclinaison d'une surface inclinée du capuchon de la broche de 35 à 45 degrés, et une épaisseur du capuchon de la broche de 1 à 1,3 mm.

6. Méthode de revêtement selon la revendication 5 pour une cellule solaire PERC de type tube, dans laquelle la fente du bateau en graphite a une profondeur de 0,7 à 0,8 mm, le diamètre de la base de la broche est de 8 à 12 mm, l'angle d'inclinaison de la surface inclinée du chapeau de la broche est de 37 à 42 degrés, et l'épaisseur du chapeau de la broche est de 1,1 à 1,2 mm.
